# EUROPÄISCHE PATENTSCHRIFT

(11) **EP 0 367 091 B1**
(45) Veröffentlichungstag und Bekanntmachung des Hinweises auf die Patenterteilung: **13.04.1994**
(21) Anmeldenummer: 89119820.2
(22) Anmeldetag: 25.10.1989
(51) Int. Cl.: H01Q 17/00, H05K 9/00

(54) **Plane zur Abschirmung von Objekten**
Blanket for shielding objects
Bâche pour le blindage d'objets

(30) Priorität: 02.11.1988 DE 8813680 U
(43) Veröffentlichungstag der Anmeldung: 09.05.1990
(73) Patentinhaber: SYNTEEN GEWEBE TECHNIK GMBH, D-79771 Klettgau (DE)
(72) Erfinder: Aisslinger Dieter, D-6222 Geisenheim (DE)
(74) Vertreter: Weiss, Peter, Dr. rer.nat.

(56) Entgegenhaltungen:
- FR-A- 2 442 422
- US-A- 3 300 781
- US-A- 3 349 396
- US-A- 4 001 827
- US-A- 4 442 162

## Beschreibung

Die vorliegende Erfindung betrifft eine Plane zur Abschirmung eines Objektes nach dem Oberbegriff des Anspruchs 1.

Besonders auf militärischem Gebiet besteht vielfach die Notwendigkeit, Objekte vor Detektion durch eine Wärmebild und/oder ein Radargerät zu schützen. Hierbei sind im wesentlichen zwei technisch-physikalische Aufgabenstellung zu beachten.

Beim Schutz des Objektes soll die von diesem ausgehende Strahlung, beispielsweise Wärmestrahlung abgeschirmt und die auf das zu detektierende Objekt gerichtete hochfrequente, elektromagnetische Strahlung absorbiert werden.

Aus US-A 3 300 781 ist eine Decke zur Verhinderung des Auffindens von darunter befindlichen Objekten, z.B. militärischer Art, durch Radar- oder Infrarot-Ortung bekannt, die sich aus mehreren metallisierten Plastikfolien zusammensetzt. Diese sind durch eine Hülle aus Baumwollstoff umgeben, von der die eine Seite weiß und die andere Seite eine Tarnfarbe aufweist. Die Abschirmung wird dann durch Aufeinanderliegen der Folien erreicht. Der Gebrauch von Plastikfolien hat erhebliche Nachteile bezüglich einer Luftzirkulation und der Herstellung.

Aus US-A 3 349 396 ist ebenfalls eine Decke, zur Abschirmung gegen Radar- und Infrarot-Ortung bekannt, die aus mehreren, von einer wasserdichten, getarnten Stofflage bedeckten Schichten besteht. Diese sind sandwichartig aufeinandergelegt und setzen sich aus einer Absorptionsfolie und einer Abstandsfolie zusammen. Erstere ist mit einem Kohlenstoff enthaltenden Elastomer beschichtet, während letztere aus einer Polyäthylenfolie mit zylinderförmigen Erhebungen geprägt ist. Auf die letzte Abstandsfolie folgt eine metallbeschichtete Plastikfolie; ein leichter Baumwollstoff bildet den Abschluß. Diese Decke stellt jedoch im Hinblick auf die verhältnismäßig große Zahl von Schichten eine aufwendige Lösung in der Herstellung dar. Ferner ist eine freie Luftzirkulation im Bereich der zylinderförmigen Erhebungen teilweise behindert.

Aufgabe der vorliegenden Erfindung ist es, eine Plane zu entwickeln, welche ein universelles und leicht handhabbares Hilfsmittel darstellt und dessen Wirkung auch über einen längeren Zeitraum hinweg erhalten bleibt.

Diese Aufgabe wird gemäß der Erfindung durch die kennzeichnenden Merkmale des Anspruchs 1 gelöst.

Hierdurch wird ein dichtes Schild auf der textilen Außenfläche geschaffen, welches hochfrequente, magnetische Strahlen in einem breiten Frequenzband absorbiert. Gleichzeitig bewirkt dieses Schutzschild auch eine Isolation in bestimmtem Umfange von einer Wärmestrahlung, welche von dem zu schützenden Objekt ausgeht.

Das Kunstharz des Schildes hat weiterhin den Vorteil, daß es gegen Witterungseinflüsse beständig ist und kein Wasser aufnimmt. Ferner ist diese Schicht nicht brennbar.

Vorzugsweise kann die eben beschriebene Schicht selbst farbig in entsprechenden Tarnfarben ausgebildet sein oder aber ist mit einer nicht emittierenden Farbschicht belegt. Hierdurch wird das gewohnte sichtoptische Aussehen hergestellt.

In einer bevorzugten Ausführungsform sind mit der textilen Außenfläche in Kette oder Schuß elektrisch leitende Fäden, wie Drähte, entsprechende Garne, Monofile und/oder Folienbändchen textiltechnisch verbunden. Diese Fäden dienen ebenfalls der Absorbtion von hochfrequenten, elektromagnetischen Wellen. Hierzu können diese elektrisch leitenden Fäden aus einer Basisfolie mit aufgebrachter Metallschicht und/oder einer elektrisch leitenden Schicht bestehen. Der Einfachheit halber werden diese Fäden aus einer entsprechend beschichteten Basisfolie herausgeschnitten, wobei diese Basisfolie die Beschichtung auch beidseitig aufweisen kann.

In einer bevorzugten Ausführungform sind die Fäden nur teilweise mit den Außenflächen verbunden und bilden das Stützgewebe zwischen den zwei entsprechenden textilen Außenflächen. Somit sind beide Außenflächen durch das Stützgewebe od. dgl. starre oder flexible Abstandshalter miteinander textiltechnisch verbunden.

Ein Vorteil dieser Ausgestaltung ist auch, daß eine Verschiebung der beiden Außenflächen relativ zueinander möglich wird. Hierdurch können Schnitte in die Außenflächen gelegt werden, welche sich dann beim Gebrauch überlappen. Damit wird eine dichte Abdeckung vor allem der Wärmestrahlung erreicht. Die Anpassung der Temperatur der Plane an die Umgebungstemperatur wird durch konvektiven Wärmeübergang der unterbrochenen Fläche verbessert.

Durch das Stützgewebe werden die beiden Außenflächen in einem bestimmten Abstand voneinander gehalten, so daß ein Zwischenraum gebildet wird. Dieser Zwischenraum dient insbesondere der Ausbildung einer die Wärmestrahlung isolierenden und durch Luftkonvektion selbst regulierenden Luftschicht. Wenn sich der Wärmegradient beispielsweise an der einen Außenfläche erhöht, so findet keine oder nur eine geringe Wärmeübertragung auf die andere Außenfläche statt. Die Wärmeleitung hängt selbstverständlich zusätzlich von dem Material und Querschnitt bzw. auch der Länge des Stützgewebes ab. Deshalb besteht bevorzugt das Stützgewebe bzw. die Abstandshalter aus sich kreuzenden Fäden mit geringem Durchmesser. Hierdurch wird die Wärmeleitung dieses Stützgewebes vernachlässigbar gering gehalten.

Im weiteren kann das Stützgewebe zusätzlich einen Überzug aus einer Kohle- oder magnetische Pigmente beinhaltenden Substanz besitzen. Auch dies dient der Verbesserung der Absorbtion von hochfrequenten, elektromagnetischen Wellen. Dieser Überzug kann beispielsweise durch Tränkung hergestellt sein, wobei in diesem Fall auch die textilen Außenflächen gleich entsprechend mitgetränkt werden.

Zur Ausbildung einer stehenden isolierenden Luftschicht kann der Zwischenraum zwischen den beiden textilen Außenflächen wasser- und luftdicht abgeschlossen sein. Deshalb hat es sich in diesem Falle als günstig erwiesen, die Kante der Plane mit einem entsprechenden Band zu versiegeln. Insbesondere bei dieser Ausführungsform ist es dann auch möglich, den Zwischenraum mit einer Quelle für Kühlmittel in Verbindung zu setzen, so daß der Zwischenraum beispielsweise mit Kühlluft gespült werden kann.

Auch diese Maßnahme dient der Abschirmung der Wärmestrahlung und/oder Änderung der Objektkontur im thermischen Bereich.

Zur weiteren konvektiven Anpassung an die Umgebungstemperatur ist es vorteilhaft, die makroskopische Oberfläche zu vergrößern. Erreicht wird dieser Effekt durch eine Prägung oder durch Verweben von Garnen oder Monofilen mit verschiedenem thermischen Schrumpfverhalten. Durch die Wärmeeinwirkung bei der Aufbringung der beschriebenen Beschichtung führt eine partielle Schrumpfung der Fäden, Garne oder Monofile zur Kräuselung der Oberfläche. Eine weitere Maßnahme zur Steigerung der konvektiven thermischen Hintergrundangleichung ist die Ausbildung der Oberflächen in Gitterform.

Bevorzugt wird, daß die textilen Außenflächen aus nicht entflammbaren Fasern oder Monofilen hergestellt sind und bevorzugt selbstlöschend sind. Es ist ferner möglich, eine entsprechende flammhemmende Ausrüstung des Textils vorzunehmen, wobei dies durch entsprechende Additive zu den Beschichtungen erzielt wird.

Durch diese erfindungsgemäße Plane wird ein schildartiges Gebilde geschaffen, welches eine sehr günstige absorbierende Wirkung bezüglich einer Wärmestrahlung bzw. bezüglich hochfrequenter, elektromagnetischer Mikrowellen aufweist. Es ist falt- und/oder rollbar und wird durch Knickungen nicht in seiner Wirksamkeit beeinträchtigt.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in
- Fig. 1: einen Querschnitt durch eine erfindungsgemäße Plane;
- Fig. 2: einen Querschnitt durch ein weiteres Ausführungsbeispiel der erfindungsgemäßen Plane gemäß Fig. 1 mit gegeneinander verschieblichen Außenflächen;
- Fig. 3: einen vergrößert dargestellten Teillängsschnitt durch einen erfindungsgemäßen, elektrisch leitenden Faden;
- Fig. 4: einen vergrößert dargestellten Teillängsschnitt durch einen flexiblen elektrischen Leiter.

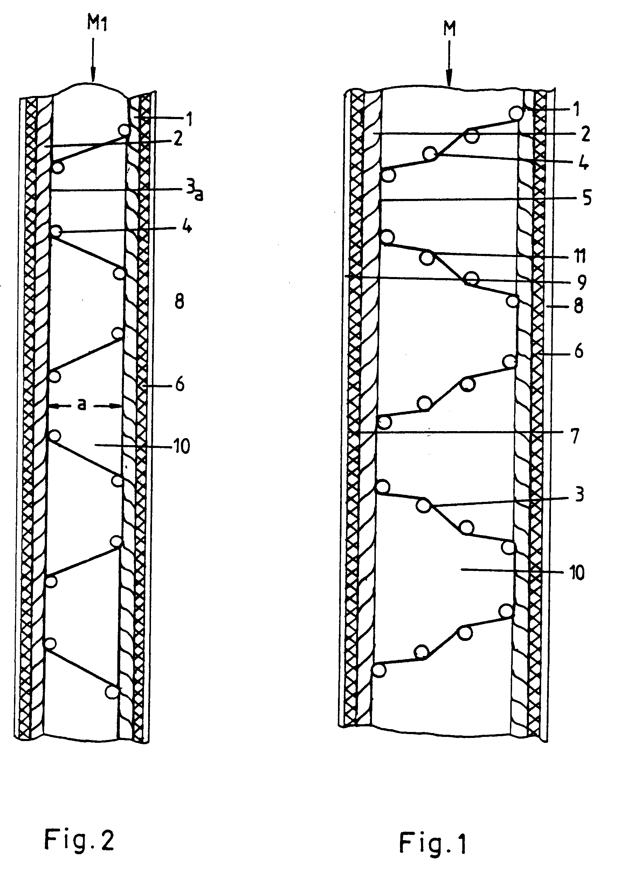

Eine Plane M besitzt gemäß Fig. 1 zwei gewobene Außenflächen 1 und 2, zwischen denen sich ein Stützgewebe 3 aus sich netzartig kreuzenden Fäden 4 und 5 befindet. Dieses Stützgewebe 3 gewährleistet, daß zwischen den beiden Außenflächen 1 und 2 ein Abstand a eingehalten wird.

Beide Außenflächen 1 und 2 sind ferner mit einer Kunstharzschicht 6 bzw. 7 überdeckt, um eine Wasseraufnahme der Plane M einzuschränken. Diese Kunstharzschichten 6 und 7 sind dann wieder mit einer nicht emittierenden Farbschicht 8 bzw. 9 belegt, um das gewohnt sichtoptische Aussehen der gesamten Plane M wieder herzustellen.

Der zwischen den Außenflächen 1 und 2 gebildete und von dem Stützgewebe 3 gesicherte Zwischenraum 10 dient als isolierende und die Luftkonvektion selbst regulierende Luftschicht, wenn sich der Wärmegradient der Außenfläche 1 in Relation zu der anderen Außenfläche 2 ändert.

Zwischen den beiden Außenflächen 1 und 2 kann lediglich eine Wärmeleitung durch die Fäden 4 und 5 des Stützgewebes 3 erfolgen. Diese Wärmeleitung ist bestimmt durch das verwendete Material für die Fäden 4 und 5, dessen Querschnitt und die anfallende Weglänge und ist somit vernachlässigbar gering.

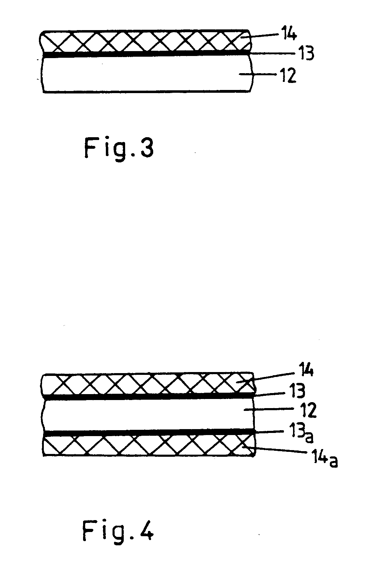

Ferner ist vorgesehen, das Stützgewebe 3 durch Tränkung mit einem Überzug 11 zu versehen, wobei dieser Überzug Kohle- und/oder magnetische Pigmente beinhaltet. Eine andere wirksame Maßnahme besteht darin, die Fäden 4 bzw. 5 des Stützgewebes 3 teilweise oder ganz mit elektrisch leitenden Fasern, Garnen oder Drähten zu bestücken. Als besonders wirksam und variierbar haben sich geschnittene Fäden aus beschichteter Folie herausgestellt, wie dies in den Fig. 3 und 4 gezeigt ist. Gemäß Fig. 3 wird auf eine Basisfolie 12 eine leitende Metallschicht 13 aufkaschiert oder beispielsweise im Vakuum aufgedampft. Als Schutzschicht wird darauf eine elektrisch leitende Schicht 1-4 aufgebracht.

In Fig. 4 ist eine weitere Ausführungsform eines Fadens 4 bzw. 5 dargestellt, wobei hier die Basisfolie 12 beidseits mit einer Metallschicht 13 bzw. 13a und einer cokonduktiven Schicht 14 bzw. 14a belegt ist.Cokonductiv bedeutet, daß Schicht 14 bzw. 14a zusammen mit Schicht 13 bzw. 13a leitet. Beide ergänzen sich und vermeiden Fehlstellen.

Diese Ausführungsform gewährleistet, daß in den im Textil beim Weben entstehenden Kreuzungspunkten entsprechende Kontakte gebildet werden. Die Fäden 4 bzw. 5 können aus den in Fig. 3 bzw. Fig. 4 gezeigten beschichteten Basisfolien geschnitten werden.

Um im übrigen eine Absorbtion von hochfrequenten Wellen zu erzielen, ist es ratsam, beide Kunstharzschichten 6 und 7 mit Kohlenstoff bis zu einer gewünschten elektrischen Leitfähigkeit zu pigmentieren. Im übrigen können alle elektrisch leitenden Schichten entsprechend der Erfindung auch mit magnetisch wirkendem kugeligem Eisenoxidgranulat angereichert sein.

Während der Aufbau der Plane M nach Fig. 1 relativ hart und unflexibel ist, zeigt Fig. 2 eine weichere, griffigere Anordnung, bei welcher das Stützgewebe 3 keine eigene absorbierende Funktion im Zwischenraum 10 zwischen den Außenflächen 1 und 2 hat und in einfacher Verbindung zu den Außenflächen 1 und 2 steht. Der Schichtaufbau dieser Plane M entspricht jedoch ansonsten demjenigen von Fig. 1. Lediglich das Stützgewebe 3a ist auf das Notwendigste zur Aufrechterhaltung seiner Funktion reduziert, wobei nur Querfäden 4 vorgesehen sind, welche eine Abstützung gegenüber den Außenflächen 1 und 2 bilden. Weitere versteifende Querfäden, wie in Fig. 1 gezeigt, sind nicht vorgesehen.

Durch diese Anordnung werden die zwei Außenflächen 1 und 2 gegeneinander verschieblich ausgestaltet. Ferner wird der schon beschriebene Effekt der Undurchlässigkeit von thermischer Strahlung beim strukturierenden Einschneiden der beiden Oberflächen bestimmt.

## Patentansprüche

1. Plane zur Abschirmung eines Objektes mit Mitteln, um thermische Wellen, die vom Objekt emittiert werden, nicht entweichen zu lassen und/oder um auf das Objekt gerichtete hochfrequente, elektromagnetische Wellen im Mikrowellenbereich, z.B. Radarwellen, zu absorbieren,
dadurch gekennzeichnet,
daß zwei textile Außenflächen (1, 2) unter Einhaltung eines eine isolierende Luftschicht bildenden Zwischenraumes (10) miteinander durch ein Stützgewebe (3, 3a) verbunden sind, welches aus mindestens teilweise mit den textilen Außenflächen (1, 2) verbundenen Fäden (4, 5) gebildet ist, wobei mindestens eine Außenfläche (1, 2,) bzw. deren Fäden mit einer im thermischen Bereich reflektierenden und/oder im Mikrowellenbereich absorbierenden Schicht (6, 7) ganz oder teilflächig belegt ist.

2. Plane nach Anspruch 1, dadurch gekennzeichent, daß die textilen Außenflächen (1, 2) zur Förderung der konvektiven Wärmeangleichung gitterartig ausgestaltet sind.

3. Plane nach Anspruch 1 oder 2, dadurch gekennzeichnet, daß das Stützgewebe (3) aus sich kreuzenden Fäden (4, 5) besteht.

4. Plane nach einem der Ansprüche 1 bis 3, dadurch gekennzeichent, daß in die Schicht (6, 7) magnetische Pulver oder Pigmente eingemischt sind.

5. Plane nach einem der Ansprüche 1 bis 4, dadurch gekennzeichnet, daß die Schicht (6, 7) mit magnetisch wirkendem, kugeligem Eisenoxidgranulat angereichert ist.

6. Plane nach einem der Ansprüche 1 bis 5, dadurch gekennzeichnet, daß auf die Schicht (6, 7) eine nicht emittierende Farbschicht (8, 9) aufgebracht ist.

7. Plane nach einem der Ansprüche 1 bis 6, dadurch gekennzeichnet, daß die Fäden der textilen Außenfläche (1, 2) in Kette oder Schuß Garne oder Monofile mit verschiedenem thermischen Schrumpfverhalten sind.

8. Plane nach einem der Ansprüche 1 bis 7, dadurch gekennzeichnet, daß in Kette oder Schuß der textilen Außenflächen (1, 2) elektrisch leitende Fäden wie Drähte, Garne, Monofile und/oder Folienbändchen eingewoben sind.

9. Plane nach Anspruch 8, dadurch gekennzeichnet, daß die elektrisch leitenden Fäden aus einer Basisfolie (12) mit einer einseitig oder beidseitig aufgebrachten Metallschicht (13, 13a) und/oder einer elektrisch leitenden Schicht (14, 14a) bestehen.

10. Plane nach Anspruch 1, dadurch gekennzeichnet, daß das Stützgewebe (3, 3a) einen Überzug (11) aus einer Kohle- oder magnetische Pigment beinhaltenden, Substanz aufweist.

11. Plane nach Anspruch 10, dadurch gekennzeichnet, daß der Überzug (11) durch Tränkung hergestellt ist, wobei auch die Außenflächen (1, 2) entsprechend getränkt sind.

12. Plane nach einem der Ansprüche 1 bis 11, dadurch gekennzeichnet, daß die Kanten der Plane (M, M1) mit einem Band od. dgl. abgedichtet sind.

13. Plane nach einem der Ansprüche 1 bis 12, dadurch gekennzeichnet, daß der Zwischenraum (10) einen Anschluß an eine Kühlmittelquelle besitzt.

## Claims

1. Blanket for shielding an object with means to prevent thermal waves emitted by the object from escaping and/or to absorb high-frequency electromagnetic waves in the microwave range, for example radar waves, directed onto the object, characterised in that two textile external surfaces (1, 2) are connected to one another by a supporting cloth (3, 3a) while maintaining an intermediate space (10) forming an insulating air layer, the supporting cloth (3, 3a) being formed from threads (4, 5) connected at least in part to the textile external surfaces (1, 2), wherein at least one external surface (1, 2) or its threads is occupied completely or over part of its area by a layer (6, 7) which reflects in the thermal range and/or absorbs in the microwave range.

2. Blanket according to claim 1, characterised in that the textile external surfaces (1, 2) are designed in the form of a grid to promote convective heat adaptation.

3. Blanket according to claim 1 or 2, characterised in that the supporting cloth (3) consists of intersecting threads (4, 5).

4. Blanket according to one of claims 1 to 3, characterised in that magnetic powders or pigments are mixed into the layer (6, 7).

5. Blanket according to one of claims 1 to 4, characterised in that the layer (6, 7) is enriched with magnetically acting spherical iron oxide granulate.

6. Blanket according to one of claims 1 to 5, characterised in that a non-emitting layer of colour (8, 9) is applied to the layer (6, 7).

7. Blanket according to one of claims 1 to 6, characterised in that the threads of the textile external surface (1, 2) in the warp or weft are yarns or monofilaments with different thermal shrinkage behaviour.

8. Blanket according to one of claims 1 to 7, characterised in that electrically conductive threads such as wires, yarns, monofilaments and/or film strips are woven in the warp or weft of the textile external surfaces (1, 2).

9. Blanket according to claim 8, characterised in that the electrically conductive threads consist of a basic film (12) with a metal layer (13, 13a) applied to one or both sides and/or of an electrically conductive layer (14, 14a).

10. Blanket according to claim 1, characterised in that the supporting cloth (3, 3a) has a covering (11) of a substance containing carbon or magnetic pigment.

11. Blanket according to claim 10, characterised in that the covering (11) is produced by impregnation, the external surfaces (1, 2) also being appropriately impregnated.

12. Blanket according to one of claims 1 to 11, characterised in that the edges of the blanket (M, M1) are sealed with a tape or the like.

13. Blanket according to one of claims 1 to 12, characterised in that the intermediate space (10) has a connection to a coolant source.

## Revendications

1. Bâche destinée à faire écran autour d'un objet par mise en oeuvre de moyens empêchant la propagation des ondes thermiques émises par l'objet et/ou absorbant les ondes électromagnétiques à haute fréquence, dans le domaine des micro-ondes, par exemple des ondes radar, dirigées sur l'objet, caractérisée en ce qu'elle est constituée de deux surfaces externes (1, 2) textiles reliées par une structure porteuse tissée (3, 3a) maintenant un espace intermédiaire (10) constituant une couche d'air isolante, cette structure étant faite de fils (4, 5) reliés au moins partiellement aux surfaces externes (1, 2) tandis qu'au moins une surface externe (1, 2) ou les fibres est revêtue, sur tout ou partie de leur surface, d'une couche (6, 7) réfléchissante dans la plage des émissions thermiques et/ou absorbante dans le domaine des micro-ondes.

2. Bâche selon la revendication 1, caractérisée en ce que les surfaces externes textiles (1, 2) ont une constitution en forme de grille afin de favoriser l'équilibrage thermique par convection.

3. Bâche selon la revendication 1 ou 2, caractérisée en ce que la structure tissée (3) est constituée de fils croisés (4, 5).

4. Bâche selon l'une quelconque des revendications 1 à 3, caractérisée en ce que des poudres magnétiques ou des pigments sont incorporés à la couche (6, 7).

5. Bâche selon l'une quelconque des revendications 1 à 4, caractérisée en ce que la couche (6, 7) est enrichie par un granulat sphérique d'oxyde de fer, à effet magnétique.

6. Bâche selon l'une quelconque des revendications 1 à 5, caractérisée en ce qu'une couche colorée (8, 9), non émissive, est déposée sur la couche (6, 7).

7. Bâche selon l'une quelconque des revendications 1 à 6, caractérisée en ce que les fils de la surface externe textile (1, 2) sont constitués, en chaîne ou en trame, de fils ou de monofilaments présentant des retraits différents sous l'action de la chaleur.

8. Bâche selon l'une quelconque des revendications 1 à 7, caractérisé en ce que des fils doués de conductibilité électrique, tels que fils simples, fils retors, monofilaments et/ou films en bandelettes, sont incorporés au tissage à la chaîne ou à la trame de la surface textile externe (1, 2).

9. Bâche selon la revendication 8, caractérisée en ce que les fils conducteurs sont réalisés à partir d'un film (12) recouvert sur une ou deux faces d'une couche métallique (13, 13a) et/ou d'une couche conductrice de l'électricité (14, 14a).

10. Bâche selon la revendication 1, caractérisée en ce que la structure tissée (3, 3a) porte un revêtement (11) fait d'une substance contenant des pigments carbones ou magnétiques.

11. Bâche selon la revendication 10, caractérisée en ce que le revêtement (11) est obtenu par imprégnation, de sorte que les surfaces externes (1, 2) sont également imprégnées.

12. Bâche selon l'une quelconque des revendications 1 à 11, caractérisée en ce que les bords de la bâche (M, M1) sont obturés de manière étanche par un ruban ou organe analogue.

13. Bâche selon l'une quelconque des revendications 1 à 12, caractérisée en ce que l'espace intermédiaire (10) est équipé d'un raccord à une source de froid.
